# EUROPÄISCHE PATENTSCHRIFT

(11) **EP 1 876 394 B1**
(45) Veröffentlichungstag und Bekanntmachung des Hinweises auf die Patenterteilung: **24.04.2019**
(21) Anmeldenummer: 07111253.6
(22) Anmeldetag: 28.06.2007
(51) Int. Cl.: G06F 3/0354, H03K 17/96, F24C 7/08, H05B 3/74

(54) **GLEITSTREIFEN MIT EINER HAPTISCHEN STRUKTURIERUNG**
TOUCH SLIDER HAVING A HAPTICAL RELIEF PATTERN
UNITÉ À CURSEUR TACTILE AVEC UNE STRUCTURE HAPTIQUE EN RELIEF

(30) Priorität: 03.07.2006 DE 102006030548
(43) Veröffentlichungstag der Anmeldung: 09.01.2008
(73) Patentinhaber: BSH Hausgeräte GmbH, 81739 München (DE)
(72) Erfinder: Meindl, Thomas, 83417, Kirchanschöring (DE); Schuhbaeck, Peter, 83329, Otting (DE); Wurnitsch, Ernst, 6382, Kirchdorf (AT)

(56) Entgegenhaltungen:
- EP-A- 0 930 806
- DE-A1- 2 755 678
- DE-A1- 10 133 135
- DE-A1- 10 201 196
- DE-A1- 10 361 350
- DE-A1-102004 002 825
- DE-A1-102004 053 769
- DE-U1- 29 519 714
- US-A1- 2005 052 426

## Beschreibung

Die Erfindung betrifft einen Gleitstreifen mit einer zumindest teilweise bedruckten Benutzeroberfläche sowie ein damit ausgerüstetes Haushaltsgerät, insbesondere ein Kochgerät, im speziellen einen Herd.

Aus DE 299 11 917 U1 ist ein Standherd mit einem eine Herdplatte aus Glaskeramik aufweisenden Einbaukochfeld bekannt, mit wenigstens einer Kochzone auf der Herdplatte, mit einer Steuerung und mit Bedienungselementen zur Bedienung der Kochzone, wobei das Einbaukochfeld unmittelbar in den Standherd eingebaut ist. Ein Bedienungselement ist als Taste auf der Herdplatte ausgebildet, und an der Frontseite des Standherdes sind Bedienknebel für einen Ofen vorhanden.

Gleitstreifen sind zur Gerätebenutzung allgemein bekannt, z. B. aus DE 35 23 284 A1 oder aus DE 101 33 135 B4.

Aus DE 27 55 678 A1 ist ein mit einer Anzeigevorrichtung gekoppelter Berührungsschalter zum stufenweisen Verstellen eines Elektrogerätes, insbesondere eines Elektroherdes, bekannt.

Nachteilig dabei ist, dass eine Bedienung der Gleitstreifen zwar als einfach angesehen wird, aber häufig, im Vergleich beispielsweise zu mechanischen Schiebern, als zu unpräzise empfunden wird, d. h., dass dem Benutzer eine empfindliche haptische Rückmeldung fehlt, die eine ihm angenehme und genaue Einstellung des Gleitstreifens ermöglicht. Dies gilt gerade in rauheren Umgebungen (z. B. in Umgebungen mit Essenresten, Fett, Strassen- oder Industriestaub oder bei häufiger Benutzung usw.).

Es ist daher die Aufgabe der vorliegenden Erfindung, ein Möglichkeit zur verbesserten Bedienerfreundlichkeit und Benutzerführung von Gleitstreifen bereitzustellen.

Die Aufgabe wird gelöst durch einen Gleitstreifen nach Anspruch 1 und ein Haushaltsgerät nach Anspruch 10. Vorteilhafte Ausgestaltungen ergeben sich insbesondere aus den Unteransprüchen einzeln oder in Kombination.

Der Gleitstreifen umfasst eine Benutzer- bzw. Bedienoberfläche, die zumindest teilweise eine haptisch wirksame Strukturierung aufweist, wodurch ein Benutzer eine signifikant bessere haptische Rückmeldung durch aktive taktile Exploration der Oberfläche bei Berührung oder Übergleiten des Gleitstreifens erhält. Dadurch kann auch unter schwierigen Umweltbedingungen der Stellstreifen sicher und genau betätigt werden, zum Beispiel in fettigen, staubigen oder feuchten Umgebungen.

Durch die haptisch wirksame Strukturierung wird typischerweise die Benutzeroberfläche des Gleitstreifens nicht mehr glatt sein, sondern "aufgeraut", d. h., bezüglich der ursprünglichen, unbedruckten Benutzeroberfläche Höhenschwankungen aufweisen. Dadurch wird der Gleitwiderstand erhöht und löst das Problem, dass ein Gleiten bisher als zu leicht und damit zu unpräzise empfunden worden ist. Zudem wird nun der zur präzisen Stellung des Gleitstreifens nachteilige sogenannte Slip-Stick-Effekt verringert oder ganz vermieden, bei dem zunächst ein höherer Haftreibungswiderstand überwunden werden muss, um dann aufgrund eines erheblich geringeren Gleitreibungswiderstands vergleichsweise schnell zu gleiten.

Die Strukturierung ist eine Bedruckung welche zur einfachen Aufbringung vorteilhaft ist.

Es ist zur erhöhten haptischen Wirkung vorteilhaft, wenn die haptisch wirksame Bedruckung eine Mehrfachbedruckung ist, da sie dann höher als bei der allgemein üblichen Einfachbedruckung und dadurch besser erfühlbar wird.

Die haptisch wirksame Bedruckung weist eine Höhe von mindestens 0,1 mm, insbesondere von mindestens 0,2 mm, auf. Damit ist eine Wirksamkeit auch bei Verschmutzung (Fett, Staub usw.) und Abrieb sichergestellt.

Es kann günstig sein, wenn die haptisch wirksame Bedruckung, einen von einer Gleitrichtung abhängigen haptischen Effekt aufweist, da der Benutzer so intuitiv eine Rückmeldung erhält, ob sein Finger entlang einer Gleitbahn gleitet oder seitlich vom Gleitstreifen abkommt.

Die haptisch wirksame Strukturierung ist eine Folge von Querlinien die einen im Wesentlichen gleichen Abstand zwischen 0,2 mm und 10 mm voneinander aufweisen.

Bei einem Zirkulargleitstreifen, sind die Querlinien gegeneinander entsprechend winkelversetzt.

Für den Fall, dass der Gleitstreifen ein Lineargleitstreifen ist, sind die Querlinien vorteilhafterweise senkrecht zur Längsachse des Lineargleitstreifens angeordnet sind, da sie so in Hauptgleitrichtung einen maximalen haptischen Effekt erzeugen.

Ein Abgleiten vom Gleitstreifen wird dadurch erschwert, dass der Gleitstreifen vorzugsweise in einer Führungsmulde angeordnet ist.

Die Aufgabe wird auch gelöst durch ein Haushaltsgerät, insbesondere ein Kochgerät, wie z. B. einen Herd, das mit zumindest einem der oben beschriebenen Gleitstreifen ausgerüstet ist, zur Einstellung zumindest eines Betriebparameters, speziell einer Kochstufe und / oder einer Timer-Funktion. Der haptische Effekt unterstützt den Bediener bei der Einstellung der Kochstufe und / oder der Timer-Funktion auch bei z. B. fettiger Oberfläche.

Im folgenden werden zwei Ausführungsbeispiele mit Hilfe von Figuren schematisch dargestellt. Die Figuren sind nicht maßstabsgerecht.
- Figur 1: zeigt eine Draufsicht auf Elemente einer Herdoberseite;
- Figur 2: zeigt eine Draufsicht auf eine Gruppe von Elementen zur Bedienung einer Kochzone des Herds aus FIG 1 einschließlich eines erfindungsgemäßen Gleitstreifens;
- Figur 3: zeigt eine seitliche Schnittdarstellung als Ausschnitt des Gleitstreifens aus FIG 2 entlang der Schnittlinie A-A;
- Figur 4: zeigt eine Draufsicht auf eine nicht erfindungsgemäßen Ausführungsform eines Gleitstreifens.

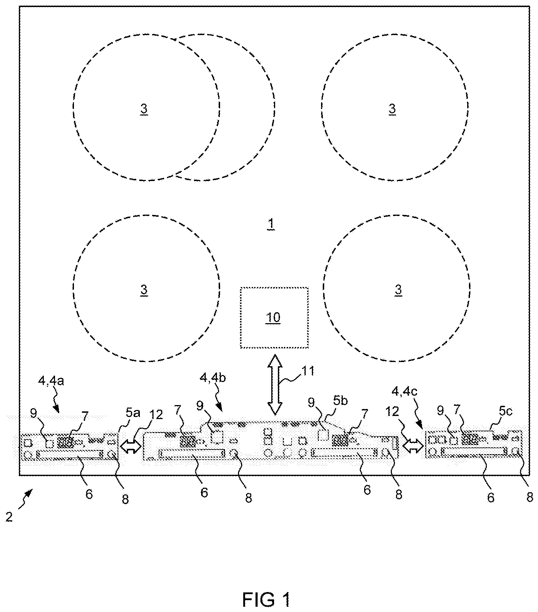

FIG 1 zeigt eine Draufsicht auf ein Kochfeld 1 eines Herds 2, mit Darstellung der Positionen einiger zugeordneter funktionaler Elemente, nämlich der Positionen von vier getrennt ansteuerbaren Kochzonen 3, die hier durch einen mittels Strahlungsheizkörpern (nicht dargestellt) beheizbaren Bereich einer Glaskeramikplatte definiert werden, sowie die Position eines Bedienfelds 4, das intern in drei Teilbedienfelder 4a, 4b, 4c unterteilt ist. Die Kochzonen 3 können zueinander unterschiedlich ausgelegt sein, z. B. funktional mit einer zusätzlichen Bräterzone (oben links dargestellte Kochzone), mit unterschiedlichen Durchmessern und / oder Heizleistungen.

Zur übersichtlichen Beschreibung des Bedienfelds 4 sind nur diejenigen Bedien- und Anzeigeelemente mit Bezugszeichen versehen, auf die im folgenden genauer eingegangen werden wird; dabei stellen runde Elemente Tasten dar, und quadratische Elemente stellen Anzeigeleuchten dar. Ausser den Tasten und Leuchten sind auch Gleitstreifen 6 (häufig "Slider" oder Stellstreifen genannt) in Form von Lineargleitstreifen und alphanumerische Anzeigen 7 in Form von 7-Segment-Anzeigen vorhanden.

Die Bedien- und Anzeigeelemente der Teilbedienfelder 4a, 4b, 4c sind auf jeweiligen Elektronikmodulen bzw. Platinen 5a, 5b, 5c aufgebracht, die geeignete elektrische Anschlüsse (nicht dargestellt) zur Stromversorgung und / oder Signalübermittlung aufweisen. In diesem Ausführungsbeispiel ist das mittlere, größte Teilbedienfeld 4b bzw. Elektronikmodul 5b als Masterbedienfeld (Hauptbedienfeld) bzw. Masterelektronikmodul 5b ausgestaltet, und die anderen Teilbedienfelder 4a, 4c bzw. Elektronikmodule 5a, 5c als Slavebedienfelder (anhängige Bedienfelder) bzw. Slaveelektronikmodule 5a, 5c. Die Slaveelektronikmodule 5a, 5c weisen jeweils eine Auswerteelektronik (nicht dargestellt) zur Umsetzung der Messsignale der ihnen zugeordneten Gleitstreifen 6 und Tasten in Datensignale auf, da eine direkte Übertragung der relativ schwachen Messignale zum Masterelektronikmodul 5b einen Auswertefehler erhöhen würde. Genauer gesagt weisen die Elektronikmodule 5a-c in dieser Ausführungsform nur den einem berührungsempfindlichen Bedienelement, z. B. dem Gleitstreifen 6, zugeordneten Messaufnehmer auf, z. B. einen kapazitiven, resistiven oder piezoelektrischen Messaufnehmer. Durch Andrücken des Messaufnehmers wird eine mechanische Kopplung mit der Geräteoberfläche, hier: einer Glaskeramik-Kochfeldplatte, bewirkt. Beim Berühren der Glaskeramikplatte oberhalb des Messaufnehmers wird diese leicht verformt, was die Messaufnehmer erfassen. Bei solchen berührungsempfindlichen Bedienelementen wird ein Bedienelement eines Bedienfelds 4 somit durch die Geräteoberfläche in Kombination mit dem angedrückten Elektronikmodul 5a-c definiert.

Nur das Masterelektronikmodul 5b ist direkt mit der zentralen Steuerschaltung 10 über einen ersten Datenbus 11 bzw. einen ersten Teil 11 eines gemeinsamen Datenbusses des Herds 2 verbunden. Die Teilelektronikmodule 5a, 5b, 5c sind zur Datenübertragung über einen zweiten Datenbus 12 bzw. einen zweiten Teil 12 des gemeinsamen Datenbusses verbunden. Der Datenbus 11,12 ist hier ein LIN ("Local Interconnect Network")-Feldbus, da dieser besonders kostengünstig realisierbar ist. Das Master-Elektronikmodul 5b entspricht dann dem LIN-Master, die anderen Elektronikmodule 5a, 5c jeweils einem LIN-Slave.

Im besonderen ist das Bedienfelds 4 mit den zugehörigen Bedien- und Anzeigeelementen so ausgestaltet, dass jede Kochzone 3 durch eine jeweilige Gruppe von Bedien- und Anzeigeelementen steuerbar ist. Jede solche Gruppe umfasst hier zumindest einen Gleitstreifen 6, eine alphanumerische Anzeige 7, ein Timer-Bedienelement 8 und eine Temperaturanzeigeleuchte 9. Der Gleitstreifen 6 dient zur Einstellung von Betriebsparametern der zugeordneten Kochzone 3, wie beispielsweise einer Kochstufe oder einer Zeiteinstellung ("Timer-Einstellung"). Die alphanumerische Anzeige 7 zeigt den Wert des gerade aktiven Betriebsparameters an. Durch Betätigung des Timer-Bedienelements 8 kann eine Zeiteinstellungsbetriebsart aktiviert werden, z. B. eine Kochzeit bei angeschalteter Kochzone 3 und eine Weckerzeit bei ausgeschalteter Kochzone 3. Die Temperaturanzeigeleuchte 9 leuchtet zur Benutzerwarnung, wenn die zugeordnete Kochzone 3 eine voreingestellte Temperatur überschreitet. Somit kann eine bestimmte Kochzone 3 nur durch die ihre zugeordnete Gruppe gesteuert werden; die Steuerung der verschiedenen Kochzonen 3 kann parallel und unabhängig erfolgen.

Andere Bedien- und Anzeigeelemente können beispielsweise einen Hauptschalter, eine Verriegelungstaste zum Wischschutz, eine Bräterzonenzuschalttaste, eine Hauptmenutaste, ein Menuanzeigefeld usw. umfassen.

In dem gezeigten Ausführungsbeispiel ist die räumliche Anordnung der Gleitstreifen 6 so, dass sie entlang einer Linie am Rand des Kochfelds 2 ausgerichtet sind, nicht entsprechend der Anordnung der Kochzonen 3, was für die Kochzonen 3 Platz schafft.

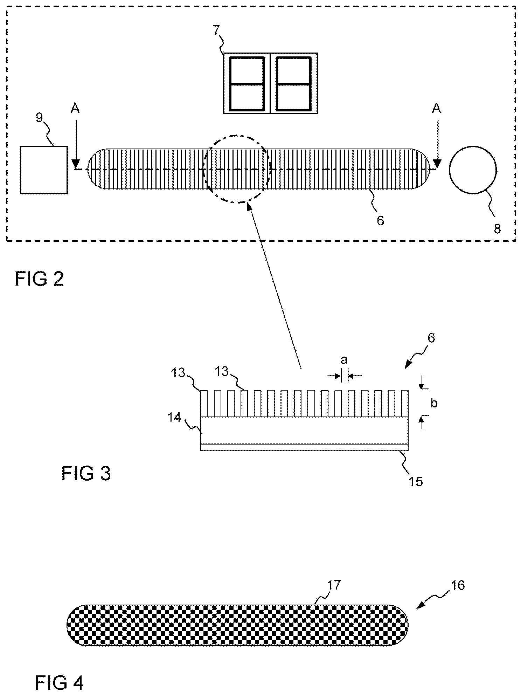

FIG 2 zeigt in Draufsicht die in FIG 1 beschriebenen Bedien- und Anzeigeelemente für eine einer bestimmten Kochzone zugeordneten Gruppe, nämlich den Gleitstreifen 6, die alphanumerische Anzeige 7, das Timer-Bedienelement 8 und die Temperaturanzeigeleuchte 9.

Der Gleitstreifen 6 weist hier eine haptische Oberflächenstrukturierung in Form von Querlinien auf, die in regelmäßigen Abständen quer zu einer Längsachse A-A ausgerichtet sind. Ein Benutzer fährt bei einer Bedienung des Lineargleitstreifens 6 typischerweise entlang der Längsachse A-A und somit quer über die Querlinien. Dadurch wird eine haptische Führung bzw. Rückmeldung des Benutzers für die Einstellung von Stellwerten auf dem Gleitstreifen verbessert.

FIG 3 zeigt einen Ausschnitt des Gleitstreifens 6 aus FIG 2 in Seitenansicht, wie er durch den gestrichpunkteten Kreis in FIG 2 angedeutet ist. Wie dem Fachmann bekannt, kann bei einem Gleitstreifen 6 die Kochplatte 14, z. B. aus Glaskeramik für kapazitive Messaufnehmer 15 oder metallisch für piezoelektrische Messaufnehmer 15, im Bereich des Gleitstreifens 6 dessen oberste Schicht darstellen, wie hier gezeigt. Unter dem dem Gleitstreifen 6 zugeordneten Teil der Kochplatte 14 ist der Messaufnehmer 15 flächig angebracht, der auf bekannte Weise bei Berührung und Verformung der Benutzeroberfläche des Gleitstreifens 6 Messsignale ausgibt, die ein Maß für die Position, Richtung und / oder Geschwindigkeit z. B. eines Fingers auf dem Gleitstreifen 6 darstellen. Mit dem Gleitstreifen 6 ist eine Elektronik (nicht dargestellt) gekoppelt, welche die vom Sensorelement 15 ausgegebenen Messsignale in Stellwerte für die zugehörige aktive Betriebsart umwandelt, z. B. eine Position, eine Richtung und / oder eine Geschwindigkeit auf einem Gleitstreifen 6 zur Einstellung oder Änderung einer Zeiteinstellung.

Auf der Bedienoberfläche des Gleitstreifens 6, welche der Oberfläche der z. B. Glaskeramikkochplatte 14 in diesem Bereich entspricht, sind Querlinien 13 durch Mehrfachbedruckung auf die ursprünglich glatte Bedienoberfläche aufgebracht worden. Durch die Querlinien 13 wird dem Benutzer eine haptische Führung bzw. Rückmeldung bereitstellt. Die Querlinien 13 weisen in Hauptbedien- bzw. Gleitrichtung entlang der Längsachse A-A den stärksten haptischen Effekt auf. Die Querlinen 13 weisen einen Abstand a in Längsrichtung A-A von ca. 0,2 mm zueinander auf und ein Höhe b von der unbedruckten Kochplatte 14 von ca. 0,4 mm. Dadurch wird ein Slip-Stick-Effekt bei gleichzeitiger starker haptischer Rückmeldung vermieden.

Aufgrund des haptischen Effekts ist eine Überdruckung eines möglicherweise vorhandenen optischen Dekors, das keine wesentliche haptische Wirkung besitzt, unkritisch, zumal die Querlinien 13 die Lage der Bedienoberfläche des Gleitstreifens 6 anzeigen. Der Gleitstreifen 6 kann zusätzlich mit einem optisch wirksamen Dekor bedruckt sein, das die Position und ggf. Fläche des Gleitstreifens 6 angibt. Ein solches Dekor ist nicht zur haptischen Führung geeignet und besteht beispielsweise aus einer Umrandung. Bei ausreichend hoher Bedruckung oder einer geeigneten Struktur könnte ggf. aber auch eine Umrandung eine haptische Wirkung entfalten.

FIG 4 zeigt eine Aufsicht auf einen nicht erfindungsgemäßen Gleitstreifen 16 analog zu FIG 2, wobei das von oben betrachtete haptische Oberflächenmuster 17 nun schachbrett- oder mosaikartig ausgebildet ist. Auch dadurch wird ein haptischer Effekt beim Benutzer erreicht, der aber im Gegensatz für Ausführungsform der FIG 2 und 3 nicht richtungsabhängig ist, sondern für jede Gleitrichtung im Wesentlichen die gleiche.

Die oben beschriebenen Gleitstreifen 6, 16 (FIG 2 und 4) sind zur besseren Benutzerführung zusätzlich in einer in die Glaskeramik eingebrachten Längsmulde (ohne Abbildung) eingebracht, die einem Benutzer ein zusätzliches Richtungsgefühl gibt. Beispielsweise kann die Längsmulde ganz von einem Gleitstreifen 6, 16 ausgefüllt sein und im Querschnitt senkrecht zur Längsrichtung A-A in die Kochplatte 12 hinein gebogen sein.

Das in den Figuren 1-3 gezeigte Ausführungsbeispiel ist nicht dazu gedacht, die Erfindung auf irgendeine Weise zu beschränken. So kann der beschriebene Gleitstreifen für alle geeigneten Hausgeräte verwendet werden, wie Herde mit Backofen, reine Kochgeräte, Waschmaschinen, Kühlschränke und sonstige Haushaltsgeräte.

Es wird dem Fachmann nach Lesen der obigen Beschreibung unter Berücksichtigung der beigefügten Zeichnungen und Ansprüche klar werden, dass unterschiedliche Umgebungen unterschiedliche haptische Stärken erfordern können.

Bei der Bedienung von Kochzonen ist die Zahl der Gleitstreifen an die Zahl der Kochzonen anpassbar (z. B. 2, 3 oder 5), kann aber auch davon abweichen, z. B., bei Verwendung eines gemeinsamen Gleitstreifens für alle Kochzonen, wobei die Steuerung dann durch eine Kochzonenauswahlumschaltung vorgenommen werden kann. Auch ist die Erfindung nicht auf Lineargleitstreifen beschränkt, sondern kann für beliebige Formen verwendet werden, z. B. Zirkulargleitstreifen, wobei dann beispielsweise Querlinien senkrecht zur gekrümmten Gleitbahn aufgebracht werden. Ferner ist die Art des einen oder der mehreren Sensorelemente des Gleitstreifens nicht beschränkt und kann z. B. kapazitive, piezoelektrische, mechanische, induktive, optische usw. Sensorarten umfassen, falls gewünscht auch in Kombination. Entsprechend kann auch die Bedienoberfläche alle dem Fachmann bekannten grundsätzlichen Ausführungsformen annehme, z. B. als Metallplatte oder als ein Schichtmaterial, dass zum Sensormaterial passt.

### Bezugszeichenliste

- 1: Kochfeld
- 2: Herd
- 3: Kochzone
- 4: Bedienfeld
- 4a: Slavebedienfeld
- 4b: Masterbedienfeld
- 4c: Slavebedienfeld
- 5a: Platine
- 5b: Platine
- 5c: Platine
- 6: Gleitstreifen
- 7: alphanumerische Anzeige
- 8: Timer-Bedienelement
- 9: Temperaturanzeigeleuchte
- 10: zentrale Steuerschaltung
- 11: Datenbus
- 12: Datenbus
- 13: Querlinie
- 14: Glaskeramikplatte
- 15: Sensorelement
- 16: Gleitstreifen
- 17: haptische Oberflächenstruktur
- a: Abstand
- b: Höhe

## Patentansprüche

1. Gleitstreifen (6) für ein Haushaltsgerät (2), wobei der Gleitstreifen durch ein Betätigen zum Einstellen zunächst eines Betriebsparameters des Haushaltsgeräts (2) ausgebildet ist, mit einer Benutzeroberfläche (14), die zumindest teilweise eine Strukturierung aufweist, die eine haptisch wirksame Strukturierung (13) ist, **dadurch gekennzeichnet, dass** die haptisch wirksame Strukturierung (13) eine Folge von Querlinien (10) ist, die einen im Wesentlichen gleichen Abstand (a) zwischen 0,2 mm und 10 mm voneinander aufweisen, wobei die haptisch wirksame Strukturierung eine Bedruckung (13) ist und die haptisch wirksame Strukturierung (13) eine Höhe (b) von mindestens 0,1 mm aufweist.

2. Gleitstreifen (6) nach Anspruch 1, **dadurch gekennzeichnet, dass** die haptisch wirksame Strukturierung eine Mehrfachbedruckung ist.

3. Gleitstreifen (6) nach Anspruch 1 oder 2, **dadurch gekennzeichnet, dass** die haptisch wirksame Strukturierung (13) eine Höhe (b) von mindestens 0,2 mm aufweist.

4. Gleitstreifen (6) nach einem der vorhergehenden Ansprüche, **dadurch gekennzeichnet, dass** die haptisch wirksame Strukturierung (13) einen von einer Gleitrichtung abhängigen haptischen Effekt aufweist.

5. Gleitstreifen (6) nach einem der vorhergehenden Ansprüche, **dadurch gekennzeichnet, dass** der Gleitstreifen ein Lineargleitstreifen (6) ist und die Querlinien (10) senkrecht zur Längsachse (A-A) des Lineargleitstreifens (6) angeordnet sind.

6. Gleitstreifen (6) nach Anspruch 5, **dadurch gekennzeichnet, dass** er in einer Führungsmulde angeordnet ist.

7. Gleitstreifen (6) nach einem der vorhergehenden Ansprüche, **dadurch gekennzeichnet, dass** der Gleitstreifen (6) zusätzlich mit einem optisch wirksamen Dekor, das keine Wesentliche haptische Wirkung besitzt, bedruckt ist.

8. Gleitstreifen (6) nach Anspruch 7, **dadurch gekennzeichnet, dass** das optisch wirksame Dekor eine Position und/oder eine Fläche des Gleitstreifens (6) angibt.

9. Gleitstreifen (6) nach Anspruch 7 oder 8, **dadurch gekennzeichnet, dass** das Dekor eine Umrandung ist.

10. Haushaltsgerät, insbesondere Kochgerät (2), mit zumindest einem Gleitstreifen (6) nach einem der vorhergehenden Ansprüche zur Einstellung zumindest eines Betriebsparameters, insbesondere einer Kochstufe und/oder einer Timer-Funktion.

## Claims

1. Sliding strip (6) for a household appliance (2), wherein the sliding strip is embodied to initially adjust an operating parameter of the household appliance (2) by way of an actuation, with a user interface (14) which at least partially has a structuring which is a haptically active structuring (13), **characterised in that** the haptically active structuring (13) is a series of transverse lines (10), which have a substantially equal distance (a) from one another of between 0.2 mm and 10 mm, wherein the haptically active structuring is an imprinting (13) and the haptically active structuring (13) has a height (b) of at least 0.1 mm.

2. Sliding strip (6) according to claim 1, **characterised in that** the haptically active structuring is a multiple imprinting.

3. Sliding strip (6) according to claim 1 or 2, **characterised in that** the haptically active structuring (13) has a height (b) of at least 0.2 mm.

4. Sliding strip (6) according to one of the preceding claims, **characterised in that** the haptically active structuring (13) has a haptic effect which is dependent upon a sliding direction.

5. Sliding strip (6) according to one of the preceding claims, **characterised in that** the sliding strip is a linear sliding strip (6) and the transverse lines (10) are arranged perpendicularly to the longitudinal axis (A-A) of the linear sliding strip (6).

6. Sliding strip (6) according to claim 5, **characterised in that** it is arranged in a guide recess.

7. Sliding strip (6) according to one of the preceding claims, **characterised in that** the sliding strip (6) is additionally imprinted with an optically active décor, which has no substantial haptic effect.

8. Sliding strip (6) according to claim 7, **characterised in that** the optically active décor specifies a position and/or a surface area of the sliding strip (6).

9. Sliding strip (6) according to claim 7, **characterised in that** the décor is a border.

10. Household appliance, in particular cooking appliance (2), with at least one sliding strip (6) according to one of the preceding claims for adjusting at least one operating parameter, in particular a cooking level and/or a timer function.

## Revendications

1. Bande de glissement (6) pour un appareil ménager (2), dans laquelle la bande de glissement est exécutée pour le réglage tout d'abord d'un paramètre d'exploitation de l'appareil ménager (2) par un actionnement, avec une surface d'utilisation (14) présentant au moins une structure partielle, qui est une structure haptique (13), **caractérisée en ce que** la structure haptique (13) est une succession de lignes transversales (10) présentant un écartement essentiellement identique (a) entre 0,2 mm et 10 mm, dans laquelle la structure haptique est une impression (13) et la structure haptique (13) présente une hauteur (b) d'au moins 0,1 mm.

2. Bande de glissement (6) selon la revendication 1, **caractérisée en ce que** la structure haptique est une impression multiple.

3. Bande de glissement (6) selon la revendication 1 ou 2, **caractérisée en ce que** la structure haptique (13) présente une hauteur (b) d'au moins 0,2 mm.

4. Bande de glissement (6) selon l'une des revendications précédentes, **caractérisée en ce que** la structure haptique (13) présente un effet haptique dépendant d'un sens de glissement.

5. Bande de glissement (6) selon l'une des revendications précédentes, **caractérisée en ce que** la bande de glissement est une bande de glissement linéaire (6) et les lignes transversales (10) sont disposées perpendiculairement à l'axe longitudinal (A-A) de la bande de glissement linéaire (6).

6. Bande de glissement (6) selon la revendication 5, **caractérisée en ce qu'**elle est disposée dans une cavité de guidage.

7. Bande de glissement (6) selon l'une des revendications précédentes, **caractérisée en ce que** la bande de glissement (6) est en outre dotée d'un décor imprimé à effet optique qui ne possède aucune propriété haptique essentielle.

8. Bande de glissement (6) selon la revendication 7, **caractérisée en ce que** le décor à effet optique indique une position et/ou une surface de la bande de glissement (6).

9. Bande de glissement (6) selon la revendication 7 ou 8, **caractérisée en ce que** le décor est une bordure.

10. Appareil ménager, en particulier appareil de cuisson (2), avec au moins une bande de glissement (6) selon l'une des revendications précédentes pour le réglage d'au moins un paramètre d'exploitation, en particulier d'un niveau de cuisson et/ou d'une fonction de minuterie.
